# FASCICULE DE BREVET EUROPEEN

(11) **EP 3 688 808 B1**
(45) Date de publication et mention de la délivrance du brevet: **01.06.2022**
(21) Numéro de dépôt: 18758939.5
(22) Date de dépôt: 31.07.2018
(51) Int. Cl.: H01L 27/146

(54) **REDIMENSIONNEMENT DES ENTITES DE DETECTION D'UN CAPTEUR D'IMAGE MATRICIEL HYBRIDE**
NEUDIMENSIONIERUNG VON DETEKTIONSEINHEITEN EINES HYBRIDEN MATRIXBILDSENSORS
RESIZING OF DETECTION ENTITIES OF A HYBRID MATRIX IMAGE SENSOR

(30) Priorité: 27.09.2017 FR 1758967; 30.01.2018 EP 18154052
(43) Date de publication de la demande: 05.08.2020
(73) Titulaire: Airbus Defence and Space SAS, 31402 Toulouse Cedex 4 (FR)
(72) Inventeur: SAINT-PE, Olivier, 31402 Toulouse Cedex 4 (FR); PASTERNAK, Frédéric, 31402 Toulouse Cedex 4 (FR)
(74) Mandataire: Plasseraud IP
(86) Numéro de dépôt international: PCT/FR2018/051970
(87) Numéro de publication internationale: WO 2019/063892

(56) Documents cités:
- US-A1- 2016 020 235
- US-A1- 2017 117 310

## Description

La présente invention concerne un redimensionnement des entités de détection d'un capteur d'image matriciel hybride.

Les capteurs d'images matriciels, dans lesquels chaque élément photosensible est situé à une intersection d'une ligne et d'une colonne de matrice, sont utilisés à ce jour non seulement pour des applications d'imagerie, mais aussi pour des applications spectrophotométriques et des applications mixtes de spectrophotométrie et d'imagerie. Dans ces deux derniers types d'applications, des éléments photosensibles qui sont adjacents dans la matrice sont destinés à détecter des intensités lumineuses relatives à des intervalles d'échantillonnage spectraux qui sont différents. Il est alors connu qu'il puisse être avantageux de collecter les flux lumineux dans des surfaces de collecte qui ont des dimensions différentes selon la direction des lignes de la matrice et celle des colonnes. Autrement dit, il est avantageux pour certaines applications que les pas de lignes et de colonnes qui sont effectifs pour l'information recueillie en utilisant le capteur d'image, soient différents.

Or la plupart des capteurs d'images matriciels qui sont disponibles à ce jour ont des pas de lignes et de colonnes pour leurs éléments photosensibles, qui sont égaux, ce qui représente une situation très généralement favorable pour les applications d'imagerie qui sont les plus nombreuses à utiliser de tels capteurs. Autrement dit, la matrice de détection des capteurs d'images est en général à motif carré. Mais concevoir et fabriquer un nouveau capteur d'image matriciel qui aurait des pas différents de lignes et de colonnes pour ses éléments photosensibles, c'est-à-dire dont la matrice de détection posséderait un motif rectangulaire, est un investissement financier considérable. Cet investissement est encore supérieur pour une utilisation dans l'espace du capteur d'image, puisqu'il est alors nécessaire de soumettre le capteur à des tests d'homologation pour application spatiale qui sont spécifiques, longs et coûteux.

Par ailleurs, il est connu de regrouper les signaux de lecture qui proviennent d'éléments photosensibles voisins à l'intérieur d'un capteur à matrice carrée, pour obtenir une information qui corresponde à un motif matriciel effectif qui soit rectangulaire. Pour cela, des signaux de détection qui proviennent de plusieurs éléments photosensibles voisins sont lus indépendamment les uns des autres puis additionnés. Mais la valeur qui résulte de l'addition est alors associée à un bruit de lecture important, puisque celui-ci résulte de la combinaison des bruits de lecture individuels des éléments photosensibles dont les signaux de lecture sont ajoutés. En outre, l'addition des signaux de lecture individuels nécessite de mettre en œuvre des composants électroniques dédiés, dont la conception, la réalisation et l'homologation pour une utilisation spatiale génèrent des coûts supplémentaires significatifs.

Indépendamment, les capteurs d'images du type CCD, pour «Charge-Coupled Device» en anglais, procurent une grande souplesse pour la programmation de la séquence de lecture, si bien qu'il est possible pour ces capteurs CCD, en une seule opération de lecture, de recueillir au travers d'une sommation de charges un signal de lecture qui concerne plusieurs cellules de détection adjacentes de la matrice photosensible. Cet avantage des capteurs CCD est encore largement utilisé pour des applications spectrophotométriques ou des applications mixtes de spectrophotométrie et d'imagerie, lorsque des surfaces effectives de forme rectangulaire sont préférables pour collecter les flux lumineux. De nos jours, si la technologie CCD est toujours disponible pour la réalisation de capteurs d'images matriciels monolithiques à base de silicium, l'offre commerciale des capteurs d'images hybrides est quasi exclusivement basée sur des circuits de lecture de type CMOS, pour <<Complementary Metal Oxide Semiconductor» en anglais. Or ces derniers n'offrent généralement pas la capacité de recueillir en une seule opération de lecture un signal de lecture correspondant à plusieurs cellules de détection adjacentes.

Par ailleurs, les capteurs d'images hybrides sont souvent dépourvus de dispositifs permettant de caractériser et/ou suivre des fluctuations à basse fréquence de sources électriques et/ou de commandes qui altèrent la stabilité d'une ligne de base photométrique, effective pour chaque capteur d'image. Or de telles fluctuations de la ligne de base photométrique altèrent les signaux de lecture qui sont délivrés par le capteur d'image. Si de telles fluctuations peuvent généralement être tolérées pour des applications d'imagerie, elles peuvent dégrader significativement la précision de mesures qui sont réalisées à l'aide d'un capteur d'image hybride pour une application spectrophotométrique, ou pour une application mixte de spectrophotométrie et d'imagerie.

Lorsqu'un capteur d'image matriciel de type hybride est utilisé, un circuit de détection et un circuit de lecture sont fabriqués séparément, puis assemblés à l'aide de connexions, dites connexions d'assemblage, qui ont une double fonction mécanique et électrique. Chaque connexion d'assemblage relie un-à-une un seul élément photosensible du circuit de détection à une seule cellule de lecture du circuit de lecture. En particulier, pour des applications dans le domaine spectral où la longueur d'onde du rayonnement est comprise entre 1,1 µm (micromètre) et 18 µm, il est connu d'utiliser une telle structure hybride du capteur d'image avec un circuit de détection qui est à base d'un alliage de mercure (Hg), cadmium (Cd) et tellure (Te), en remplacement du silicium qui n'absorbe plus dans ce domaine spectral. D'autres alliages peuvent être utilisés tels que InGaAs, pour indium-gallium-arsenic et InSb pour indium-antimoine, ainsi que des structures de type super-réseaux qui sont désignées par QWIP ou T2SL par l'Homme du métier. Mais le risque que certains éléments photosensibles d'un tel circuit de détection soient défectueux, est supérieur, car la qualité cristalline de ces alliages semi-conducteurs est inférieure à celle du silicium. Alors, il est connu de prévoir un réseau de connexions électriques et de commutateurs contrôlables dans le circuit de lecture, qui permet de combiner les signaux de détection qui sont produits par plusieurs éléments photosensibles, ou de combiner les signaux de lecture qui sont délivrés par plusieurs cellules de lecture. De telles combinaisons de signaux permettent d'exclure ceux des éléments photosensibles du circuit de détection qui ont été identifiés comme étant défectueux, tout en conservant des capacités effectives de collecte des flux lumineux dans la matrice du capteur d'image. Mais l'intégration du réseau de connexions et de commutateurs contrôlables qui est nécessaire pour cela utilise une surface importante du circuit de lecture et se fait au détriment des performances du capteur d'images matriciel de type hybride. Par ailleurs, une telle architecture est généralement peu flexible en termes de choix de combinaisons des signaux provenant d'éléments photosensibles connexes.

Le document US 2016/020235 divulgue des assemblages de détection d'images, dans lesquels un premier substrat qui incorpore une matrice d'éléments photosensibles est connecté par des liaisons capacitives à un second substrat qui incorpore des circuits de traitement des signaux de détection.

Le document US 2017/117310 concerne un capteur d'images formé par superposition d'un circuit de détection à plusieurs éléments photosensibles et d'un circuit logique de pilotage des éléments photosensibles.

A partir de cette situation, un but de la présente invention est de fournir à faibles coûts de développement des capteurs d'images matriciels de type hybride qui procurent des surfaces non-carrées, notamment rectangulaires, effectives pour collecter les flux lumineux.

Un autre but de l'invention est de permettre d'adapter simplement, à faible coût et à faible risque, la forme des surfaces qui sont effectives à l'intérieur de la matrice de détection pour collecter les flux lumineux.

Un autre but encore de l'invention est de fournir de tels capteurs d'images matriciels à surfaces effectives qui ne sont pas carrées pour collecter les flux lumineux, pour lesquels le bruit qui est associé à chaque signal de lecture est faible.

Un autre but encore de l'invention est de fournir de tels capteurs d'images matriciels, pour lesquels certaines fluctuations qui affectent au moins un des signaux de lecture peuvent être caractérisées. En particulier, les fluctuations à caractériser peuvent concerner une ligne de base photométrique qui est effective pour le capteur d'image utilisé.

Un autre but encore de l'invention est de fournir de tels capteurs d'images matriciels à surfaces effectives qui ne sont pas carrées pour collecter les flux lumineux, pour lesquels le nombre de signaux à lire est réduit.

Enfin, lorsque le capteur d'image est destiné à une application spatiale, un but supplémentaire de l'invention est de fournir un capteur d'image matriciel à surfaces effectives qui ne sont pas carrées pour collecter les flux lumineux, sans qu'il soit nécessaire d'effectuer une nouvelle procédure d'homologation pour application spatiale.

Pour atteindre l'un au moins de ces buts ou d'autres, un premier aspect de l'invention propose un procédé de redimensionnement des entités de détection d'un capteur d'image matriciel hybride selon la revendication 1. Un tel capteur d'image matriciel hybride comprend :
- un circuit de détection, comprenant lui-même une matrice d'éléments photosensibles avec un pas de lignes et un pas de colonnes, ces pas de lignes et de colonnes pouvant être égaux mais pas nécessairement, et chaque élément photosensible étant situé à une intersection d'une ligne et d'une colonne ;
- un circuit de lecture, comprenant une matrice de cellules de lecture qui possède le même pas de lignes et le même pas de colonnes que le circuit de détection, chaque cellule de lecture étant située à une intersection d'une des lignes et d'une des colonnes ; et
- des connexions d'assemblage du circuit de détection au circuit de lecture, qui sont disposées entre ces deux circuits et conçues chacune initialement pour relier rigidement et électriquement, selon une affectation initiale de un-à-une, un seul des éléments photosensibles à une seule des cellules de lecture qui est destinée initialement à cet élément photosensible, séparément des autres connexions d'assemblage afin de transférer à la cellule de lecture le signal de détection qui est produit par l'élément photosensible sous l'effet d'un rayonnement reçu.

Selon l'invention, des connexions électriques qui sont portées par le circuit de détection ou par le circuit de lecture, et qui aboutissent aux connexions d'assemblage, sont modifiées par rapport à l'affectation initiale de un-à-une, pour relier électriquement un sous-ensemble de plusieurs éléments photosensibles adjacents à une seule des cellules de lecture qui devient dédiée à ce sous-ensemble d'éléments photosensibles, séparément d'autres sous-ensembles d'éléments photosensibles, de façon à former des entités de détection composées.

Par modifier des connexions électriques, on entend de concevoir de nouvelles connexions électriques qui sont différentes de celles prévues pour l'affectation initiale un-à-une de chaque élément photosensible à une cellule de lecture respective, puis de fabriquer le circuit de détection et/ou le circuit de lecture avec les nouvelles connexions électriques en remplacement des connexions électriques qui réalisaient l'affectation initiale de un-à-une. En particulier, les modifications des connexions électriques qui sont visées par l'invention couvrent des connexions électriques dont les chemins de connexion sont déviés ou déplacés, et/ou des connexions électriques qui sont ajoutées et/ou des connexions électriques qui sont supprimées. Les circuits de détection et de lecture ainsi modifiés sont assemblés ensuite l'un à l'autre par l'intermédiaire des connexions d'assemblage, de préférence sans modification de la méthode d'assemblage. Eventuellement, le nombre des connexions d'assemblage peut être modifié pour l'invention, mais pas nécessairement.

Ainsi, l'invention propose d'utiliser des circuits de détection et de lecture qui ont été conçus pour affecter un seul élément photosensible du circuit de détection à chaque cellule de lecture du circuit de lecture, en modifiant cette affectation initiale de un-à-une pour regrouper plusieurs éléments photosensibles pour une seule cellule de lecture. Les modifications matérielles qui sont nécessaires pour cela ne concernent que des connexions électriques, si bien que le coût peut en être réduit. En outre, ces modifications ne concernent que des connexions électriques passives, sans commutateurs contrôlables et sans qu'aucun composant électronique actif existant soit modifié, et aussi sans qu'aucun composant électronique actif supplémentaire ne soit nécessaire. Elles ne remettent donc pas en cause des homologations pour application spatiale qui auraient été obtenues antérieurement pour le circuit de détection et pour le circuit de lecture avec l'affectation un-à-une de chaque élément photosensible séparément à une cellule de lecture différente.

La disposition relative, à l'intérieur de la matrice du circuit de détection, des éléments photosensibles adjacents qui sont regroupés pour une même cellule de lecture peut être quelconque, selon l'application envisagée pour le capteur d'image. En particulier, ils peuvent être alignés dans une même ligne ou une même colonne de la matrice, ou bien être regroupés à l'intérieur d'un pavé bidimensionnel de forme quelconque qui réunit plusieurs segments de lignes adjacents et plusieurs segments de colonnes adjacents.

Enfin, les signaux de détection qui sont produits simultanément par tous les éléments photosensibles d'une même entité de détection composée, formée selon l'invention, sont lus lors d'une opération de lecture unique qui est exécutée par celle des cellules de lecture qui est dédiée à cette entité de détection composée. Le signal de lecture résultant n'est donc affecté qu'une seule fois par le bruit de lecture, si bien que le bruit total qui affecte ce signal de lecture, comprenant aussi le bruit photonique, peut rester faible ou réduit. Par ailleurs, le nombre d'opérations élémentaires de lecture est réduit, si bien que la séquence complète de lecture du capteur d'image tel que modifié selon l'invention peut être répétée, ou bien la bande passante électrique de l'électronique de lecture qui est située en aval du capteur d'image peut être réduite, conduisant dans les deux cas à une réduction supplémentaire du bruit total.

Selon une caractéristique de l'invention, des connexions électriques supplémentaires qui sont portées par le circuit de lecture, sont modifiées en outre pour raccorder électriquement aux cellules de lecture connectées aux sous-ensembles de plusieurs éléments photosensibles, selon une réaffectation de ressources du circuit de lecture, des composants électroniques qui appartenaient initialement à des cellules de lecture mais dont ces cellules de lecture n'ont pas été dédiées à des sous-ensembles de plusieurs éléments photosensibles. Il est ainsi possible d'adapter les caractéristiques des cellules de lecture encore utilisées, aux caractéristiques des sous-ensembles d'éléments photosensibles formés selon l'invention. Ces caractéristiques qui sont ainsi adaptées peuvent concerner notamment la dynamique des signaux de lecture, ou le facteur de conversion électron-tension de l'opération de lecture, ou le bruit de l'opération de lecture. En particulier, les composants électroniques qui sont raccordés selon la réaffectation de ressources du circuit de lecture, peuvent être des condensateurs, notamment des condensateurs d'intégration, des condensateurs de filtrage ou des condensateurs de lecture. De préférence, ces condensateurs peuvent être contenus dans des niveaux de métallisation du circuit de lecture.

De préférence, les connexions électriques qui sont modifiées pour relier électriquement chaque sous-ensemble de plusieurs éléments photosensibles à une seule des cellules de lecture qui devient dédiée à ce sous-ensemble d'éléments photosensibles, appartiennent à des niveaux de métallisation du circuit de détection ou du circuit de lecture. Au sens de l'invention, les niveaux de métallisation d'un circuit incluent des niveaux de matériaux diélectriques tels que des oxydes et/ou des nitrures. Etant donné que les niveaux de métallisation des circuits ne nécessitent qu'une technologie simple pour leur fabrication, leurs modifications pour appliquer l'invention ne provoquent pas de surcoûts importants.

De préférence aussi, les connexions électriques qui sont modifiées pour l'invention peuvent l'être de sorte que les sous-ensembles de plusieurs éléments photosensibles adjacents qui sont reliés à des cellules de lecture différentes, forment un motif de pavage qui est répété dans la matrice du circuit de détection. Possiblement, ils peuvent former plusieurs motifs de pavage qui sont chacun répétés dans des zones respectives de la matrice du circuit de détection.

Possiblement, certaines des connexions d'assemblage peuvent aussi être modifiées ou supprimées, en plus des connexions électriques qui sont modifiées, pour relier électriquement chaque sous-ensemble d'éléments photosensibles à la cellule de lecture qui est dédiée à ce sous-ensemble d'éléments photosensibles.

Selon un perfectionnement possible de l'invention, au moins une des cellules de lecture du circuit de lecture qui n'est plus affectée à un élément photosensible après le redimensionnement des entités de détection réalisé selon l'invention, peut être dédiée à caractériser des fluctuations qui affectent au moins un des signaux de lecture. Autrement dit, certaines des connexions électriques qui sont portées par le circuit de détection ou le circuit de lecture peuvent être modifiées en outre pour supprimer la liaison électrique qui était prévue dans l'affectation initiale de un-à-une des éléments photosensibles aux cellules de lecture, entre un des éléments photosensibles et une des cellules de lecture, dite cellule de référence. Les connexions électriques sont en outre modifiées pour connecter électriquement une entrée de cette cellule de référence de sorte qu'elle délivre en sortie un signal représentatif de fluctuations qui affectent un signal de lecture délivré par au moins une autre des cellules de lecture qui reste reliée à au moins un élément photosensible. Le signal qui est produit en sortie par la cellule de référence peut alors être utilisé pour compenser certaines des fluctuations qui affectent des signaux de lecture délivrés par d'autres cellules de lecture, notamment par celles qui sont affectées selon l'invention aux sous-ensembles de plusieurs éléments photosensibles.

Selon une première façon possible de mettre en œuvre ce perfectionnement, certaines des connexions électriques qui sont portées par le circuit de détection ou le circuit de lecture peuvent être modifiées en outre pour connecter l'entrée de la cellule de référence à une première borne d'un condensateur, dit condensateur d'entrée, et pour connecter une seconde borne du condensateur d'entrée à une borne de masse du circuit de détection ou du circuit de lecture. Avantageusement, le condensateur d'entrée pouvait appartenir à une autre des cellules de lecture dans l'affectation initiale de un-à-une des éléments photosensibles aux cellules de lecture, cette autre cellule de lecture n'étant plus connectée à aucun des éléments photosensibles après que les entités de détection composées ont été formées. Pour cela, certaines des connexions électriques qui sont portées par le circuit de détection ou le circuit de lecture peuvent être modifiées en outre pour isoler électriquement les première et seconde bornes du condensateur d'entrée par rapport à d'autres composants de ladite autre cellule de lecture. En particulier, le condensateur d'entrée peut être un condensateur d'intégration de ladite autre cellule de lecture avant que les entités de détection composées aient été formées.

Selon une seconde façon possible de mettre en œuvre le perfectionnement, la connexion électrique qui était prévue dans l'affectation initiale de un-à-une des éléments photosensibles aux cellules de lecture, pour relier électriquement un des éléments photosensibles à la connexion d'assemblage correspondante, peut être supprimée. Alors, une connexion électrique supplémentaire peut être ajoutée au circuit de détection pour connecter électriquement la connexion d'assemblage à la borne de masse du circuit de détection. Dans ce cas, la cellule de référence est celle des cellules de lecture qui est reliée électriquement à la connexion d'assemblage devenue connectée directement à la borne de masse du circuit de détection.

De façon générale, le capteur d'image matriciel hybride auquel est appliqué le procédé de redimensionnement de l'invention, peut être destiné à une application spectrophotométrique ou à une application mixte de spectrophotométrie et d'imagerie. Pour de telles applications, certaines des entités de détection composées, formées selon l'invention, peuvent être destinées à détecter des flux lumineux qui sont relatifs à des intervalles d'échantillonnage spectraux différents.

Le circuit de détection peut être en matériau semi-conducteur silicium, notamment lorsqu'il est destiné à détecter des rayonnements dont la longueur d'onde est comprise entre 200 nm (nanomètre) et 1,1 µm. Alternativement, le circuit de détection peut comporter une couche active en alliage de mercure, cadmium et tellure. Cette dernière constitution est adaptée en particulier lorsque le circuit de détection est destiné à détecter des rayonnements de longueur d'onde comprise entre 1,1 µm et 18 µm en remplacement du silicium qui n'absorbe plus dans ce domaine spectral. D'autres alliages peuvent être utilisés pour la couche active, tels que InGaAs et InSb, ainsi que des structures de type super-réseaux QWIP ou T2SL. De façon usuelle, on entend par couche active d'un circuit de détection une couche de celui-ci dans laquelle sont formés les éléments photosensibles.

D'une façon générale mais non obligatoire, le procédé de l'invention peut comprendre en outre une étape de fabrication du capteur d'image matriciel hybride, conformément aux connexions électriques modifiées, de façon à ce que le capteur d'image matriciel hybride comporte les entités de détection composées.

Enfin, un second aspect de l'invention propose un capteur d'image matriciel hybride, qui a été conçu et fabriqué en mettant en œuvre un procédé de redimensionnement de ses entités de détection conforme au premier aspect de l'invention. Dans un tel capteur d'image, le pas des lignes et le pas des colonnes des éléments photosensibles dans la matrice du circuit de détection, peuvent être identiques. Mais les pas des sous-ensembles d'éléments photosensibles, qui constituent les entités de détection composées formées selon l'invention, selon la direction des lignes et celle des colonnes de la matrice du circuit de détection, peuvent être différents l'un de l'autre dans une partie au moins de cette matrice.

D'autres particularités et avantages de la présente invention apparaîtront dans la description ci-après d'exemples de réalisation non limitatifs, en référence aux dessins annexés, dans lesquels :
- la figure 1 est une vue en perspective d'un capteur d'image matriciel hybride auquel l'invention peut être appliquée ;
- la figure 2 est un diagramme électrique de principe d'une cellule de détection et d'une cellule de lecture qui sont associées, telles que ces cellules peuvent être mises en œuvre dans un capteur d'image matriciel hybride conforme à la figure 1 ;
- la figure 3a est un schéma hybride d'un capteur d'image conforme aux figures 1 et 2, tel que connu avant la présente invention, ce schéma étant formé pour partie par une coupe de circuit de détection et pour partie par un diagramme électrique du circuit de lecture ;
- les figures 3b et 3c correspondent à la figure 3a, en illustrant deux exemples de mise en œuvre de l'invention ;
- la figure 4 est une vue en plan qui illustre une affectation possible des éléments photosensibles d'un capteur d'image, telle que résultant de l'invention ; et
- les figures 5a, 5b et 6 sont des diagrammes électriques de principe pour des perfectionnements de l'invention qui permettent de caractériser des fluctuations d'une tension de polarisation du circuit de détection.

Pour raison de clarté, les dimensions des éléments qui sont représentés dans ces figures ne correspondent ni à des dimensions réelles ni à des rapports de dimensions réels. En outre, des références identiques qui sont indiquées dans des figures différentes désignent des éléments identiques ou qui ont des fonctions identiques.

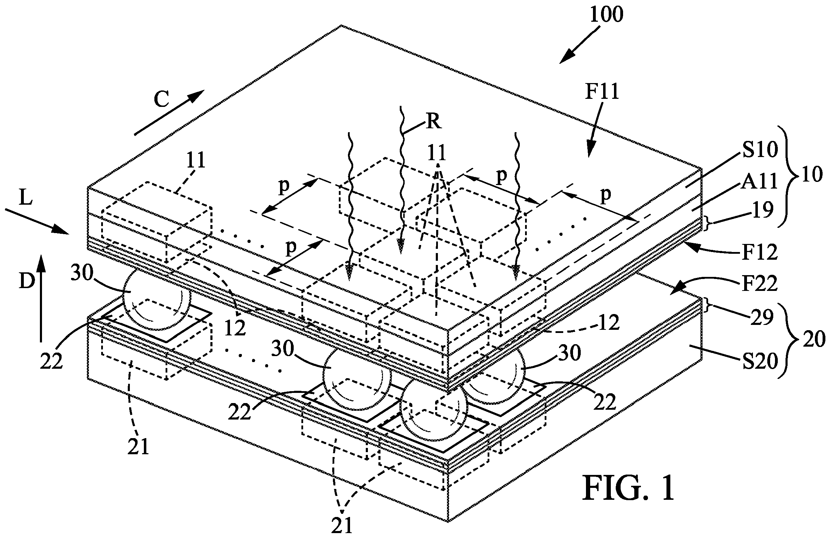

Conformément à la figure 1, un capteur d'image matriciel hybride 100, auquel l'invention peut être appliquée, comprend un circuit de détection 10 et un circuit de lecture 20, qui sont superposés selon la direction d'assemblage D. Dans des plans orthogonaux à la direction D, les circuits 10 et 20 sont chacun formés par une juxtaposition de cellules qui sont identiques à l'intérieur de chaque circuit, selon une disposition matricielle qui est commune à ces deux circuits. La matrice de cette disposition est composée de lignes et de colonnes perpendiculaires, aux croisements desquelles sont situées les cellules des circuits 10 et 20. Les références L et C désignent les directions de lignes et de colonnes de la matrice, respectivement. Les pas de lignes et de colonnes sont communs au circuit de détection 10 et au circuit de lecture 20 pour permettre aux cellules de détection et de lecture d'être alignées une-à-une selon la direction d'assemblage D. Les pas de la matrice, mesurés parallèlement aux lignes et aux colonnes, peuvent être différents mais sont le plus souvent égaux, correspondant à une matrice à motif carré, par exemple égaux à 15 µm. En illustrant le cas d'égalité, la référence p dans les figures 1, 3a-3c et 4 désigne le pas de lignes et de colonnes de la matrice qui est commune aux circuits 10 et 20.

Les cellules du circuit de détection 10 sont en général toutes identiques, séparées spatialement les unes des autres, et comprennent chacune un élément photosensible 11, et un plot de contact électrique 12 qui est relié électriquement à l'une des bornes de l'élément photosensible 11. Les éléments photosensibles 11 peuvent être des photodiodes, et sont destinés à recevoir un rayonnement lumineux R à travers la face d'entrée F11 du circuit de détection 10. La face d'entrée F11 est opposée à la face de connexions électriques F12 qui porte les plots de contact électrique 12. La nature du substrat qui est utilisé pour constituer un tel circuit de détection 10 peut être variable, et sélectionnée en fonction du domaine de sensibilité spectrale qui est désiré. Par exemple, un substrat à base de silicium (Si) peut être utilisé pour une détection dans les domaines visible et proche infrarouge, dont la réunion correspond à des valeurs de longueur d'onde pour le rayonnement R qui sont comprises entre 200 nm et 1,1 µm. Alternativement, un substrat à base d'alliage de cadmium (Cd), zinc (Zn) et tellure (Te) portant une couche active d'alliage de mercure (Hg), cadmium et tellure peut être utilisé pour une détection dans le domaine infrarouge plus lointain, correspondant à des valeurs de longueur d'onde qui sont comprises entre 1,1 µm et 18 µm, et qui regroupe les intervalles connus sous les acronymes SWIR pour «Short Wavelength InfraRed>>, MWIR pour «Mid Wavelength InfraRed» ; LWIR pour «Long Wavelength InfraRed» et VLWIR pour «Very Long Wavelength InfraRed>>. D'autres alliages peuvent encore être utilisés alternativement, pour couvrir tout ou partie du domaine de longueur d'onde infrarouge, tels que InGaAs et InSb déjà cités, ainsi que des structures de type super-réseaux QWIP ou T2SL aussi déjà citées. Dans la figure 1, la référence S10 désigne le substrat du circuit de détection 10, et la référence A11 désigne sa couche active. Dans certains cas, le substrat S10 est retiré après que la couche active A11 a été formée, si bien que le substrat S10 n'existe plus dans le circuit de détection final 10. En outre, d'une façon qui est connue pour la technologie des semi-conducteurs, des niveaux de métallisation 19 peuvent être disposés entre les éléments photosensibles 11 et les plots de contact électrique 12, mais pas nécessairement. Une telle structure de circuit de détection matriciel est bien connue de l'Homme du métier, si bien qu'il n'est pas nécessaire de la décrire plus ici. Notamment, le circuit de détection 10 comprend en outre des éléments supplémentaires, qui ne sont pas représentés ni décrits car n'étant pas concernés directement par l'invention. En particulier, il comprend une connexion de fermeture de circuit électrique, qui relie des bornes des éléments photosensibles 11 opposées à celles connectées aux plots de contact 12.

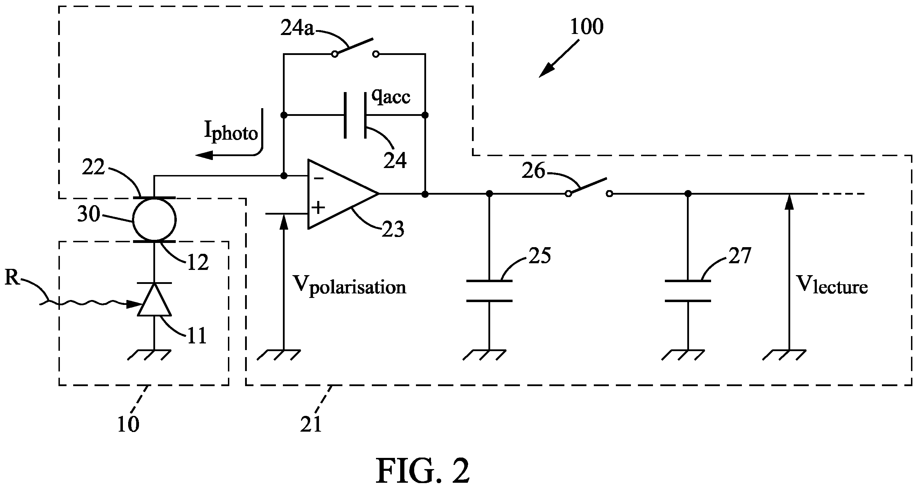

Les cellules du circuit de lecture 20 sont des cellules de lecture 21, dont la fonction individuelle est de transformer le signal de détection qui est produit par l'un des éléments photosensibles 11 du circuit de détection 10, aussi appelé signal de détection, en une tension électrique qui constitue le signal de lecture. Les cellules de lecture 21 d'un même circuit de lecture 20 sont séparées spatialement les unes des autres, et sont en général toutes identiques. Elles peuvent être de différents types selon le circuit de lecture, notamment des types CTIA pour «Capacitive Trans-Impedance Amplifier» en anglais, SFD pour «Source Follower per Detector», DI pour «Direct Injection», BDI pour «Buffered Direct Injection», etc. L'invention sera décrite à titre d'exemple non-limitatif pour des cellules de lecture du type CTIA, en relation avec la figure 2 décrite plus loin. Chaque cellule de lecture 21 est connectée à un plot de contact électrique 22, séparément des autres cellules de lecture. Les plots de lecture 22 sont tous situés sur la face F22 du circuit de lecture 20, qui est destinée à venir en vis-à-vis de la face F12 du circuit de détection 10 dans l'assemblage du capteur d'image hybride 100. Par ailleurs, et d'une façon qui est connue pour les circuits intégrés, des niveaux de métallisation 29 sont disposés entre les plots de contact électrique 22 et une partie d'un substrat S20 du circuit de lecture 20 qui contient les cellules de lecture 21. Une telle structure de circuit de lecture matriciel est aussi bien connue de l'Homme du métier. Le circuit de lecture 20 comprend aussi des éléments supplémentaires qui ne sont pas concernés directement par l'invention, et donc qui ne sont pas représentés ni décrits. Le circuit de lecture 20 est le plus souvent de type CMOS.

Le circuit de détection 10 est assemblé avec le circuit de lecture 20 au moyen d'éléments d'assemblage 30, un élément différent 30 étant dédié à chaque couple qui est formé par une cellule de détection du circuit 10 et une cellule de lecture du circuit 20 qui sont en vis-à-vis selon la direction d'assemblage D. Chaque élément d'assemblage 30 connecte ainsi mécaniquement et électriquement un plot de contact électrique 12 avec un plot de contact électrique 22. Les circuits 10 et 20 ainsi assemblés constituent le capteur d'image matriciel hybride 100. Tout type d'éléments d'assemblage peut être utilisé, notamment des billes d'indium qui sont désignées par «bumps» en anglais, et il est entendu que l'invention est indépendante du type des éléments d'assemblage et compatible avec n'importe quel type d'éléments d'assemblage.

Par exemple, un tel capteur d'image matriciel hybride, auquel l'invention peut être appliquée, peut être le modèle NGP, pour «Next Generation Panchromatic^{®}>>, qui est fabriqué par la société Sofradir^{®} et qui est conforme à la figure 2. Cette figure montre une photodiode qui constitue l'élément photosensible 11, ainsi que le plot de contact électrique 12 associé, pour une cellule de détection du circuit de détection 10. Elle montre aussi les principaux composants de la cellule de lecture 21 associée, conformément au type CTIA de cellules de lecture. Ces composants comprennent le plot de contact électrique 22, un amplificateur opérationnel 23, un condensateur d'intégration 24, un commutateur de réinitialisation 24a, un condensateur de filtrage 25, un commutateur de transfert 26 et un condensateur de lecture 27. Le commutateur de réinitialisation 24a est contrôlé pour réinitialiser le condensateur d'intégration 24 entre deux périodes d'accumulation successives. Le commutateur de transfert 26 est contrôlé à la fin de chaque période d'accumulation pour transférer au condensateur de lecture 27 le signal d'accumulation q_{acc} qui a été produit par l'élément photosensible 11 dans le condensateur d'intégration 24 sous l'effet du rayonnement R. Le condensateur de lecture 27 génère ainsi une tension électrique Viecture qui constitue le signal de lecture, et qui est transmise après multiplexage vers une sortie électrique du capteur d'image 100, à travers un ou plusieurs étages d'amplification (non représentés) et par l'intermédiaire d'un circuit d'adressage (non représenté). L'amplificateur opérationnel 23 transmet la tension de polarisation en sens inverse Vₚₒₗₐᵣᵢₛₐₜᵢₒₙ à la photodiode, et Iₚₕₒₜₒ désigne le courant électrique de formation du signal d'accumulation q_{acc}. Le courant Iₚₕₒₜₒ a été appelé signal de détection plus haut dans la présente description. Un tel fonctionnement d'une entité de détection de rayonnement est bien connu de l'Homme du métier, et des explications supplémentaires sont disponibles en abondance dans la littérature concernée.

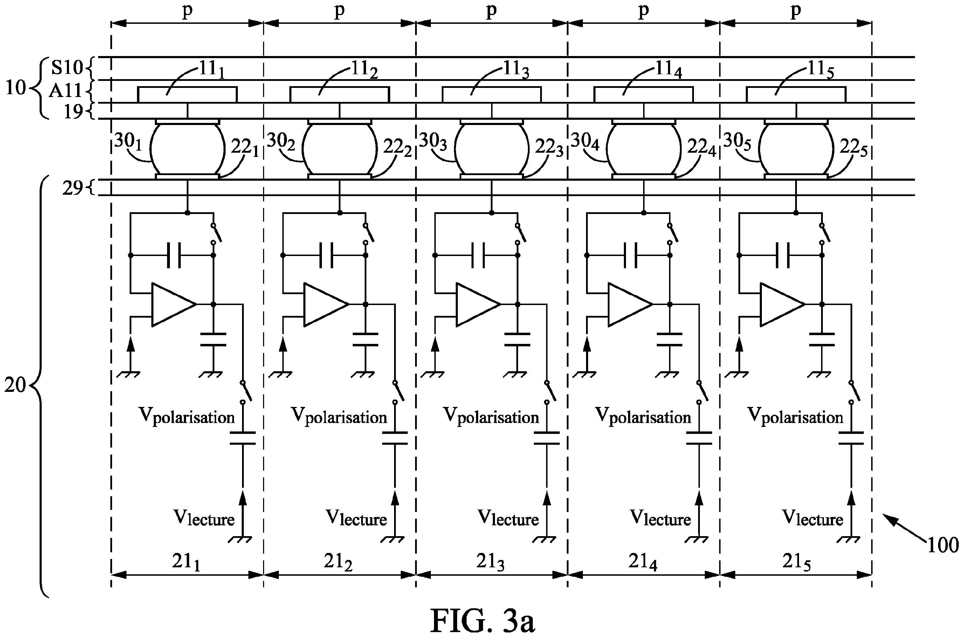

Dans une configuration initiale du capteur d'image matriciel hybride 100, les niveaux de métallisation 19 du circuit de détection 10 ne forment aucune connexion électrique qui regroupe les signaux de détection Iₚₕₒₜₒ qui sont produits par deux éléments photosensibles 11 différents. De même, le circuit de détection 10 ne comporte pas de connexion électrique sur sa face F12, au niveau des plots de contact électrique 12, qui regroupe les signaux de détection Iₚₕₒₜₒ qui sont produits par deux éléments photosensibles 11 différents. Dans la partie générale de la présente description, l'expression «connexions électriques portées par le circuit de détection (respectivement circuit de lecture)» concerne aussi bien des connexions électriques qui sont intégrées au circuit de détection 10 (resp. circuit de lecture 20) dans ses niveaux de métallisation 19 (resp. 29), que des connexions surfaciques qui peuvent être présentes au niveau des plots de contact électrique 12 (resp. 22) au-dessus des niveaux de métallisation. Aussi dans la configuration initiale du capteur d'image matriciel hybride 100, les niveaux de métallisation 29 du circuit de lecture 20 ne forment aucune connexion électrique qui regroupe les signaux de détection Iₚₕₒₜₒ qui proviennent de cellules de détection différentes. Et encore de même, le circuit de lecture 20 ne comporte pas de connexions électriques sur sa face F22, au niveau des plots de contact électrique 22, qui regroupe les signaux de détection Iₚₕₒₜₒ qui proviennent de cellules de détection différentes. L'association initiale qui est ainsi réalisée par chaque élément d'assemblage 30, d'un seul élément photosensible 11 avec chaque cellule de détection 21, indépendamment des autres éléments photosensibles et des autres cellules de détection, a été appelée affectation initiale un-à-une dans la partie générale de la présente description. Elle est illustrée par la figure 3a, dans laquelle les références 11ₙ, n étant un indice entier de 1 à 5, désignent cinq éléments photosensibles voisins du circuit de détection 10, les références 21ₙ désignent les cellules de lecture du circuit de lecture 20 qui sont affectées initialement aux cinq éléments photosensibles 11ₙ, les références 22ₙ désignent les plots de contact électrique des cellules de lecture 21ₙ, et les références 30ₙ désignent les éléments d'assemblage qui relient un-à-une les éléments photosensibles 11ₙ aux cellules de lecture 21ₙ.

L'invention consiste en une modification de cette affectation initiale un-à-une pour regrouper électriquement plusieurs éléments photosensibles pour une même cellule de détection.

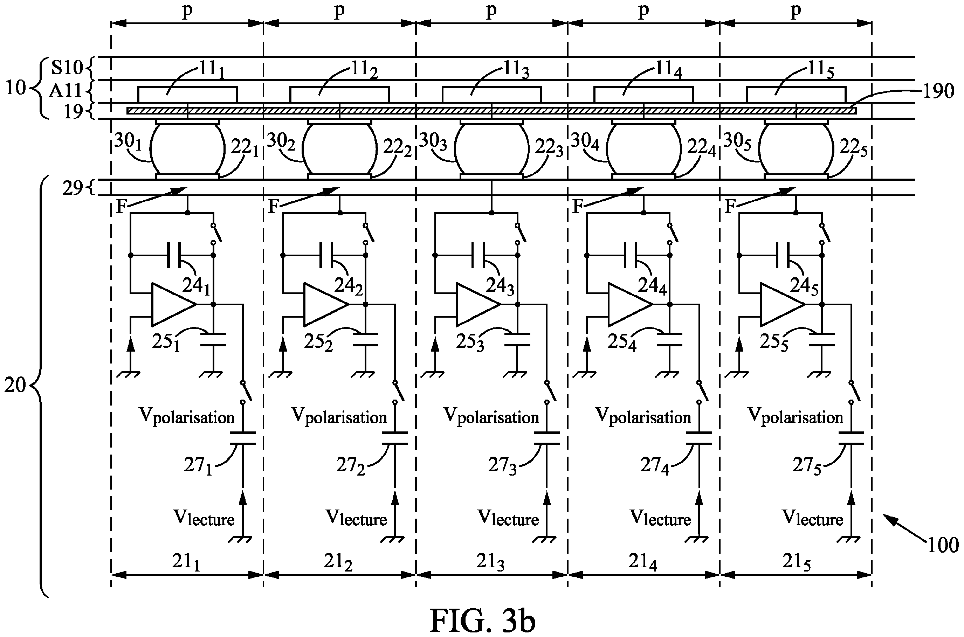

Conformément à la figure 3b, les niveaux de métallisation 19 du circuit de détection 10 sont modifiés pour contenir un ensemble de connexions électriques 190 qui connecte en parallèle les éléments photosensibles 11₁-11₅ des cinq cellules de détection représentées. Simultanément, les niveaux de métallisation 29 du circuit de lecture 20 sont modifiés pour supprimer les connexions électriques qui reliaient selon l'affectation initiale, le plot de contact électrique 22₁ à la cellule de lecture 21₁, le plot de contact électrique 22₂ à la cellule de lecture 21₂, le plot de contact électrique 22₄ à la cellule de lecture 21₄, et le plot de contact électrique 22₅ à la cellule de lecture 21₅. Ces suppressions de connexions électriques sont indiquées par les flèches F dans la figure 3b. La connexion électrique qui relie le plot de contact électrique 22₃ à la cellule de lecture 21₃ est conservée. Ainsi, les signaux de détection Iₚₕₒₜₒ qui sont produits par les cinq éléments photosensibles 11₁-11₅, sont additionnés et lus par la cellule de lecture 21₃. Les cellules de lecture 21₁, 21₂, 21₄ et 21₅ ne sont alors plus utilisées pour produire des signaux de lecture d'image.

D'une façon équivalente au mode de mise en œuvre de l'invention qui est illustré par la figure 3b, les suppressions de connexions électriques qui sont indiquées par les flèches F peuvent être réalisées en modifiant le procédé d'assemblage du circuit de détection 10 au circuit de lecture 20. Une telle modification pourrait alors être réalisée en supprimant les éléments d'assemblage 30₁, 30₂, 30₄ et 30₅, et en ne conservant que l'élément d'assemblage 30₃.

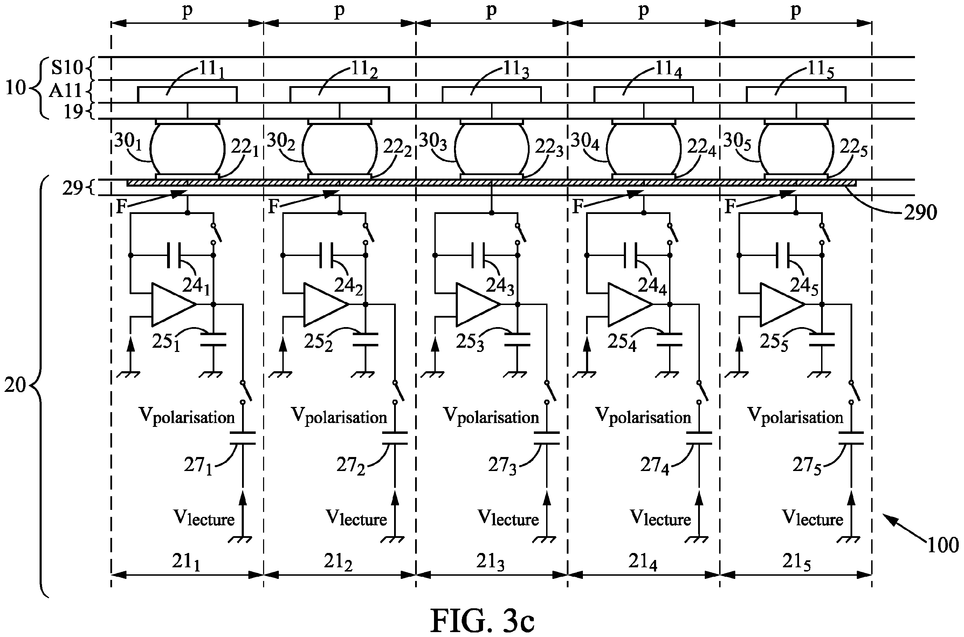

La figure 3c montre un mode de réalisation alternatif de l'invention, dans lequel le circuit de détection 10 et les éléments d'assemblage 30₁-30₅ ne sont pas modifiés par rapport à leurs configurations initiales, mais les niveaux de métallisation 29 du circuit de lecture 20 sont modifiés pour supprimer la connexion électrique entre le plot de contact électrique 22₁ et la cellule de lecture 21₁, et aussi celle entre le plot de contact électrique 22₂ et la cellule de lecture 21₂, et celle entre le plot de contact électrique 22₄ et la cellule de lecture 21₄, et celle entre le plot de contact électrique 22₅ et la cellule de lecture 21₅. Les flèches F désignent encore ces suppressions de connexions électriques. Simultanément, les niveaux de métallisation 29 sont modifiés en outre pour connecter électriquement les plots de contact électrique 22₁, 22₂, 22₄ et 22₅ au plot de contact électrique 22₃, en générant la connexion électrique 290 qui a le même rôle fonctionnel que la connexion électrique 190 de la figure 3b. La connexion électrique du plot de contact électrique 22₃ à la cellule de lecture 21₃ est maintenue. De nouveau, les cellules de lecture 21₁, 21₂, 21₄ et 21₅ ne sont plus utilisées pour produire des signaux de lecture.

De façon équivalente, les ensembles de connexions électriques 190 ou 290 qui sont ajoutés dans les circuits 10 et 20 de l'une des manières décrites ci-dessus en référence aux figures 3b et 3c, peuvent être situées au niveau des plots de contact électrique 12 ou 22 au lieu d'être situées dans les niveaux de métallisation 19 ou 29. Dans tous les cas, les modifications ne concernent pas de composants actifs, ni modifient les pas de lignes et de colonnes de la matrice commune aux deux circuits 10 et 20. Ces modifications sont donc simples à réaliser dans tous les cas, sans causer de surcoûts importants par rapport au capteur d'image 100 tel que conçu initialement conformément à l'affectation un-à-une entre les éléments photosensibles et les cellules de lecture.

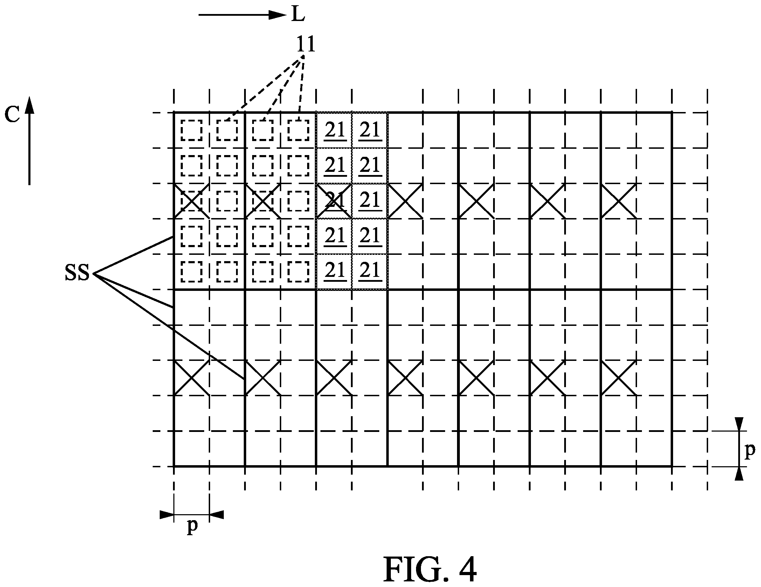

La figure 4 montre le pavage de la matrice du capteur d'image 100 qui peut ainsi être obtenu. Les éléments photosensibles 11 sont regroupés par rectangles indépendants d'éléments photosensibles adjacents, par exemple de deux éléments photosensibles 11 selon la direction des lignes L par cinq éléments photosensibles 11 selon la direction des colonnes C. Chaque rectangle de 2x5 cellules marqué en trait épais correspond à un sous-ensemble SS d'éléments photosensibles 11 qui est séparé des autres sous-ensembles à l'intérieur de la matrice. Il est connecté à une seule cellule de lecture 21 conformément à la nouvelle affectation produite selon l'invention entre éléments photosensibles et cellules de lecture. La cellule de lecture 21 qui est utilisée pour chaque sous-ensemble SS est marquée par une croix. Lors de la détection du rayonnement R par le capteur d'image 100 ainsi modifié, chaque sous-ensemble SS de plusieurs éléments photosensibles 11 a la fonction d'une seule entité de détection de rayonnement. Pour cette raison il a été appelé entité de détection composée dans la partie générale de la présente description, et l'invention a permis de réaliser ainsi un redimensionnement des entités de détection qui sont effectives dans le capteur d'image matriciel hybride 100.

Du fait que plusieurs éléments photosensibles 11 deviennent connectés à une même cellule de lecture 21, la nouvelle affectation libère des cellules de lecture 21, qui sont devenues inutiles. Or il peut être utile de modifier en plus les caractéristiques de chaque cellule de lecture 21 qui est utilisée dans la nouvelle affectation (marquée par une croix dans la figure 4), notamment pour l'adapter à la nouvelle dynamique du signal d'accumulation total qui résulte de la mise en parallèle des éléments photosensibles 11 d'un même sous-ensemble SS. Des modifications des cellules de lecture 21 qui sont utilisées dans la nouvelle affectation peuvent aussi être utiles pour adapter le facteur de conversion électron-tension, ou pour réduire le bruit de lecture qui est associé à ces cellules de lecture 21 utilisées dans la nouvelle affectation. En particulier et en se référant aux figures 3b et 3c, les condensateurs d'intégration 24₁, 24₂, 24₄ et 24₅ peuvent être isolés électriquement des autres composants de leurs cellules de lecture initiales 21₁, 21₂, 21₄ et 21₅, et connectés électriquement au condensateur d'intégration 24₃ de la cellule 21₃, par exemple selon un mode de connexion en parallèle. Le condensateur d'intégration équivalent qui en résulte peut posséder une capacité supérieure, capable de recevoir simultanément les signaux de détection Iₚₕₒₜₒ qui sont produits par les cinq éléments photosensibles 11₁-11₅. Ces modifications de connexions électriques, qui concernent les condensateurs d'intégration 24₁-24₅, peuvent être réalisées dans les niveaux de métallisation 29 du circuit de lecture 20, à faible coût et faible risque, et sans exiger une nouvelle procédure d'homologation pour application spatiale. Eventuellement, des condensateurs supplémentaires peuvent être ajoutés dans les niveaux de métallisation 29 du circuit de lecture 20, et raccordés au condensateur d'intégration 24₃. Diverses méthodes pour produire des condensateurs à l'intérieur des niveaux de métallisation d'un circuit intégré sont bien connues de l'Homme du métier.

Pour le type CTIA de cellules de lecture et en se référant aux figures 3b et 3c, les condensateurs de lecture 27₁, 27₂, 27₄ et 27₅ peuvent aussi être isolés électriquement des autres composants des cellules de lecture 21₁, 21₂, 21₄ et 21₅, et connectés électriquement au condensateur de lecture 27₃ de la cellule 21₃. Une telle modification de connexions électriques peut être mise en œuvre notamment pour réduire le bruit de lecture qui est associé à la cellule de lecture 21 utilisée dans la nouvelle affectation.

Le même principe de réaffectation de composants électroniques, depuis des cellules de lecture qui sont devenues inutilisées dans la nouvelle affectation, vers les cellules de lecture qui sont connectées aux sous-ensembles de plusieurs éléments photosensibles, peut être appliqué à n'importe quel composant électronique des cellules de lecture 21₁-21₅, y compris aux condensateurs de filtrage 25₁-25₅, ce qui permet encore de réduire le bruit de lecture qui est associé à la cellule de lecture 21 utilisée dans la nouvelle affectation. L'Homme du métier comprendra qu'une telle réaffectation de composants électroniques dépend du type des cellules de lecture 21 du circuit 20 et des caractéristiques qui sont désirées pour celles des cellules de lecture 21 qui restent utilisées.

Le circuit de détection 10 et le circuit de lecture 20 peuvent alors être fabriqués chacun en appliquant les modifications de connexions électriques objets de l'invention, pour l'un au moins de ces deux circuits. Ils peuvent être fabriqués en mettant en œuvre les procédés connus de l'Homme du métier de la fabrication des circuits intégrés, y compris des étapes de dépôts de matériaux, masquage, gravure, métallisation, etc. Puis les circuits 10 et 20 sont assemblés l'un à l'autre comme décrit plus haut.

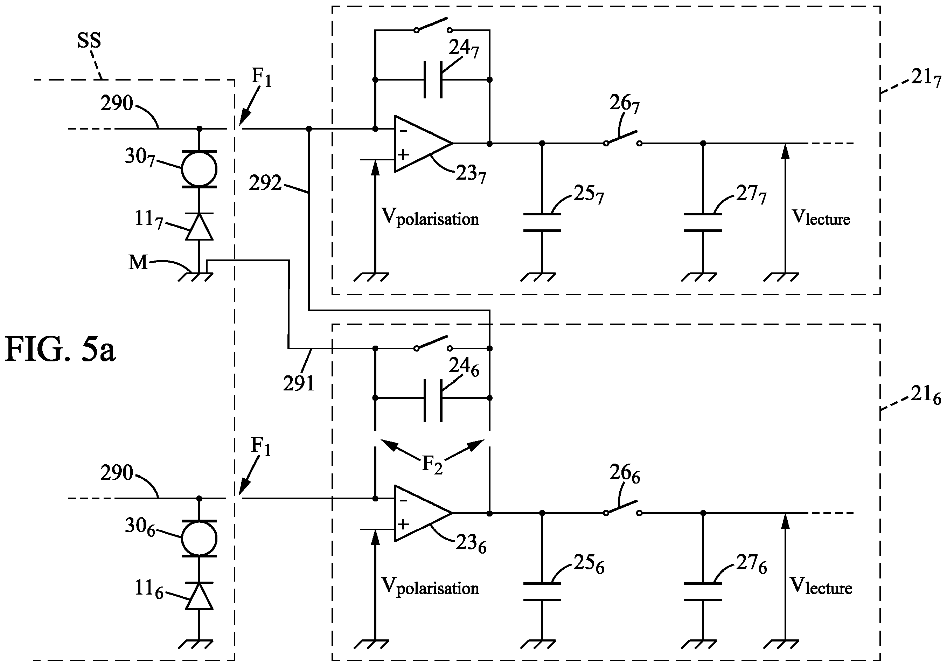

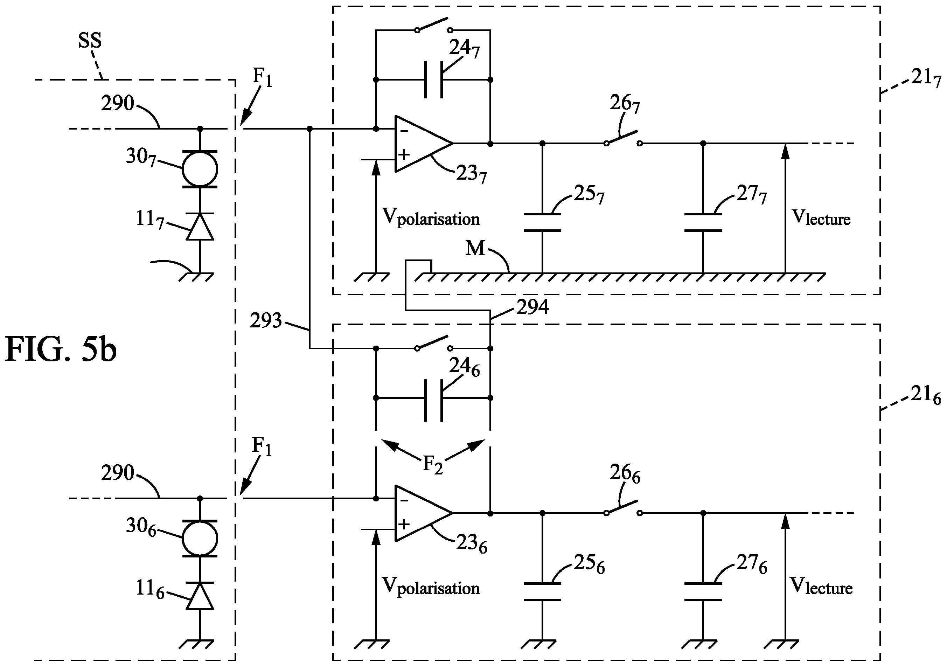

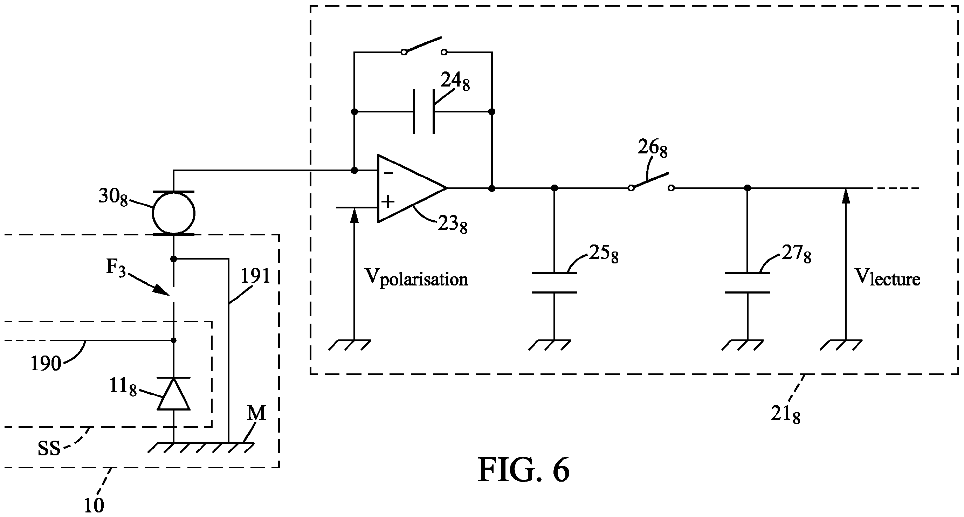

Les figures 5a, 5b et 6 montrent encore une autre utilisation possible de certaines des cellules de lecture du circuit de lecture 20 qui ne sont plus utilisées pour produire des signaux de lecture d'image.

Dans la figure 5a, l'élément photosensible 11₆ était prévu pour être connecté à la cellule de lecture 21₆ par l'intermédiaire de l'élément d'assemblage 30₆, et l'élément photosensible 11₇ était prévu pour être connecté à la cellule de lecture 21₇ par l'intermédiaire de l'élément d'assemblage 30₇, dans l'affectation initiale de un-à-une des éléments photosensibles aux cellules de lecture. Les connexions électriques dans le circuit de lecture 20 peuvent alors être modifiées pour couper celle qui relie l'élément photosensible 11₆ à la cellule de lecture 21₆, et celle qui relie l'élément photosensible 11₇ à la cellule de lecture 21₇, comme indiqué par les deux flèches F₁. Simultanément, les connexions électriques au sein de la cellule de lecture 21₆ qui relient les deux bornes du condensateur d'intégration 24₆ à une partie restante de cette cellule de lecture, sont aussi coupées, comme indiqué par les flèches F₂, et deux connexions électriques supplémentaires 291 et 292 sont ajoutées au circuit de lecture 20. La connexion 291 relie l'une des bornes du condensateur 24₆ à une borne de masse M du circuit de détection 10. La connexion 292 relie l'autre borne du condensateur 24₆ à l'entrée de la cellule de lecture 21₇. Alors, pour le type CTIA de cellule de lecture, la cellule de lecture 21₇ délivre en sortie, en tant que signal de lecture Viecture, un signal qui représente les fluctuations à basse fréquence de la tension de polarisation Vₚₒₗₐᵣᵢₛₐₜᵢₒₙ. Une telle détection de fluctuations est d'autant meilleure pour représenter celles qui affectent les signaux de lecture délivrés par les cellules de lecture encore connectées à des éléments photosensibles, que le condensateur 24₆ possède une valeur de capacité qui est proche de celles des éléments photosensibles. La cellule de lecture 21₇ ainsi exploitée a été appelée cellule de référence dans la partie générale de la description, et le condensateur 24₆ a été appelé condensateur d'entrée, puisqu'il est connecté à l'entrée de la cellule de référence. Le signal qui est délivré par la cellule de référence 21₇ représente des fluctuations d'une ligne de base photométrique qui est commune à toutes les entités de détection du capteur d'image. Il peut alors être utilisé pour compenser ces fluctuations telles qu'elles existent au sein de chaque signal de lecture tel que délivré par l'une quelconque des cellules de lecture connectées aux entités de détection. Conformément à l'invention, les éléments photosensibles 11₆ et 11₇ participent à un sous-ensemble SS pour former une entité de détection composée, par exemple conformément au mode de modification des connexions électriques qui est illustré par la figure 3c.

Alternativement, au lieu d'être récupéré d'une cellule de lecture devenue inutilisée, le condensateur d'entrée de la cellule de référence 21₇ peut être ajouté au circuit de lecture 20 parmi les modifications qui sont introduites selon l'invention dans ses connexions électriques. En effet, il est bien connu de l'Homme du métier d'incorporer un condensateur dans les niveaux de métallisation d'un circuit intégré.

La figure 5b montre une variante du mode de réalisation de la figure 5a, dans laquelle le condensateur 24₆ est isolé électriquement de la même façon par rapport à la cellule de lecture 21₆, mais est reconnecté différemment, encore selon l'invention, pour que la cellule de lecture 21₇ délivre de nouveau un signal représentatif des certaines des fluctuations de la ligne de base photométrique. Les connexions électriques ajoutées 291 et 292 sont remplacées par de nouvelles connexions électriques 293 et 294 de la façon suivante : la connexion électrique 293 relie de nouveau l'une des bornes du condensateur 24₆ à l'entrée de la cellule de lecture 21₇, et la connexion 294 relie l'autre borne du condensateur 24₆ à une borne de masse M du circuit de lecture 20. Cet autre mode de connexion du condensateur d'entrée de la cellule de référence permet de détecter plus précisément des fluctuations de la tension de polarisation Vₚₒₗₐᵣᵢₛₐₜᵢₒₙ, telles que ces fluctuations existent à l'endroit où la tension de polarisation est effective pour influencer les signaux de lecture V_{lecture} délivrés par celles des cellules de lecture qui sont encore connectées aux éléments photosensibles.

Dans la figure 6, l'élément photosensible 11₈ était prévu pour être connecté à la cellule de lecture 21₈ par l'intermédiaire de l'élément d'assemblage 30s, dans l'affectation initiale de un-à-une des éléments photosensibles aux cellules de lecture. Les connexions électriques dans le circuit de détection 10 peuvent alors être modifiées pour couper celle entre l'élément photosensible 11₈ et l'élément d'assemblage 30s, comme indiqué par la flèches F₃. Une connexion électrique supplémentaire 191 est simultanément ajoutée, pour connecter électriquement au sein du circuit de détection 10 l'élement d'assemblage 30s à la masse M de ce circuit de détection 10. Alors, du fait d'une valeur de capacité qui est effective pour l'élement d'assemblage 30₈, et pour le type CTIA de cellule de lecture, la cellule de lecture 21₈ délivre en sortie, en tant que signal de lecture Viecture, un signal qui représente les fluctuations à basse fréquence de la tension de polarisation Vₚₒₗₐᵣᵢₛₐₜᵢₒₙ. La cellule de lecture 21₈ ainsi exploitée est encore une cellule de référence au sens utilisé dans la partie générale de la description, et l'élément d'assemblage 30₈ a la fonction du condensateur d'entrée. Le signal qui est délivré par la cellule de référence 21₈ représente donc de nouveau des fluctuations d'une ligne de base photométrique qui est commune à toutes les entités de détection du circuit de détection 20, et peut encore être utilisé pour compenser ces fluctuations telles qu'elles existent au sein de chaque signal de lecture tel que délivré par l'une quelconque des cellules de lecture connectées aux entités de détection. Conformément à l'invention, l'élément photosensible 11₈ participe à un sous-ensemble SS pour former une entité de détection composée, par exemple conformément au mode de modification des connexions électriques qui est illustré par la figure 3b.Il est entendu que l'invention peut être reproduite en modifiant des aspects secondaires de la description détaillée qui vient d'être donnée, tout en conservant certains au moins des avantages qui ont été cités. Parmi les aspects secondaires qui ne sont pas directement reliés aux buts ni à la reproduction de l'invention, et qui peuvent être modifiés, on peut rappeler les suivants :
- le type de composants qui constituent les éléments photosensibles 11,
- le type des cellules de lecture 21,
- le type du substrat qui est utilisé pour le circuit de détection 10,
- le type de séquence qui est mis en œuvre pour un fonctionnement de saisie d'image par le capteur 100,
- la localisation des connexions électriques qui sont modifiées selon l'invention,
- le type des connexions d'assemblage du circuit de détection 10 au circuit de lecture 20,
- les dimensions du capteur d'image 100, en nombres de lignes et de colonnes,
- les pas de lignes et de colonnes du capteur d'image 100, et
- le type d'applications auxquelles le capteur d'image 100 est destiné.

## Revendications

1. Procédé de redimensionnement des entités de détection d'un capteur d'image matriciel hybride (100), ledit capteur d'image matriciel hybride comprenant :
- un circuit de détection (10), comprenant une matrice d'éléments photosensibles (11) avec un pas de lignes et un pas de colonnes, chaque élément photosensible étant situé à une intersection d'une ligne et d'une colonne ;
- un circuit de lecture (20), comprenant une matrice de cellules de lecture (21) qui possède le même pas de lignes et le même pas de colonnes que le circuit de détection (10), chaque cellule de lecture étant située à une intersection d'une des lignes et d'une des colonnes ; et
- des connexions d'assemblage (30) du circuit de détection (10) au circuit de lecture (20), qui sont disposées entre ledit circuit de détection et ledit circuit de lecture, et qui sont conçues chacune initialement pour relier rigidement et électriquement, selon une affectation initiale de un-à-une, un seul des éléments photosensibles (11) à une seule des cellules de lecture (21) qui est destinée initialement audit élément photosensible, séparément des autres connexions d'assemblage afin de transférer à la cellule de lecture un signal de détection (Iₚₕₒₜₒ) qui est produit par l'élément photosensible sous l'effet d'un rayonnement (R) reçu,
dans lequel des connexions électriques qui sont portées par le circuit de détection (10) ou par le circuit de lecture (20), et qui aboutissent aux connexions d'assemblage (30), sont modifiées par rapport à ladite affectation initiale de un-à-une, pour relier électriquement un sous-ensemble (SS) de plusieurs éléments photosensibles (11₁-11₅) adjacents à une seule des cellules de lecture (21₃) qui devient dédiée audit sous-ensemble d'éléments photosensibles, séparément d'autres sous-ensembles d'éléments photosensibles, de façon à former des entités de détection composées, **caractérisé en ce que** des connexions électriques supplémentaires qui sont portées par le circuit de lecture (20), sont modifiées en outre pour raccorder électriquement aux cellules de lecture (21₃) connectées aux sous-ensembles (SS) de plusieurs éléments photosensibles (11₁-11₅), selon une réaffectation de ressources du circuit de lecture, des composants électroniques qui appartenaient initialement à des cellules de lecture (21₁, 21₂, 21₄, 21₅) mais dont lesdites cellules de lecture n'ont pas été dédiées à des sous-ensembles de plusieurs éléments photosensibles.

2. Procédé selon la revendication 1, suivant lequel les connexions électriques qui sont modifiées pour relier électriquement chaque sous-ensemble (SS) de plusieurs éléments photosensibles (11₁-11₅) à une seule des cellules de lecture (21₃) qui devient dédiée audit sous-ensemble d'éléments photosensibles, appartiennent à des niveaux de métallisation (19, 29) du circuit de détection (10) ou du circuit de lecture (20).

3. Procédé selon la revendication 1 ou 2, suivant lequel les connexions électriques qui sont portées par le circuit de détection (10) ou par le circuit de lecture (20) et qui sont modifiées pour former les entités de détection composées, sont modifiées de sorte que les sous-ensembles (SS) de plusieurs éléments photosensibles (11₁-11₅) adjacents qui sont reliés à des cellules de lecture (21₃) différentes, forment un motif de pavage qui est répété dans la matrice du circuit de détection (10), ou plusieurs motifs de pavage qui sont chacun répétés dans des zones respectives de la matrice du circuit de détection.

4. Procédé selon l'une quelconque des revendications précédentes, suivant lequel certaines des connexions d'assemblage (30) peuvent en outre être modifiées ou supprimées, en plus des connexions électriques qui sont modifiées, pour relier électriquement chaque sous-ensemble (SS) d'éléments photosensibles (11₁-11₅) à la cellule de lecture (21₃) qui est dédiée audit sous-ensemble d'éléments photosensibles.

5. Procédé selon l'une quelconque des revendications précédentes, suivant lequel les composants électroniques qui sont raccordés selon la réaffectation de ressources du circuit de lecture (20), sont des condensateurs, notamment des condensateurs d'intégration (24₁, 24₂, 24₄, 24₅), des condensateurs de filtrage (25₁, 25₂, 25₄, 25₅) ou des condensateurs de lecture (27₁, 27₂, 27₄, 27₅), et de préférence des condensateurs qui sont contenus dans des niveaux de métallisation (29) du circuit de lecture.

6. Procédé selon l'une quelconque des revendications précédentes, suivant lequel certaines des connexions électriques qui sont portées par le circuit de détection (10) ou le circuit de lecture (20) sont modifiées en outre pour supprimer une liaison électrique qui était prévue dans l'affectation initiale de un-à-une des éléments photosensibles (11) aux cellules de lecture (21), entre un des éléments photosensibles et une des cellules de lecture, dite cellule de référence (21₇),
et pour connecter électriquement une entrée de la cellule de référence (21₇) de sorte que ladite cellule de référence délivre en sortie un signal représentatif de fluctuations qui affectent un signal de lecture délivré par au moins une autre des cellules de lecture (21₃) qui reste reliée à au moins un élément photosensible (11₁-11₅).

7. Procédé selon la revendication 6, suivant lequel certaines des connexions électriques qui sont portées par le circuit de détection (10) ou le circuit de lecture (20) sont modifiées en outre pour connecter l'entrée de la cellule de référence (21₇) à une première borne d'un condensateur, dit condensateur d'entrée (24₆), et pour connecter une seconde borne du condensateur d'entrée à une borne de masse (M) du circuit de détection ou du circuit de lecture.

8. Procédé selon la revendication 7, suivant lequel le condensateur d'entrée (24₆) appartenait à une autre des cellules de lecture (21₆) dans l'affectation initiale de un-à-une des éléments photosensibles (11) aux cellules de lecture (21), cette autre cellule de lecture n'étant plus connectée à aucun des éléments photosensibles après que les entités de détection composées ont été formées,
et certaines des connexions électriques qui sont portées par le circuit de détection (10) ou le circuit de lecture (20) sont modifiées en outre pour isoler électriquement les première et seconde bornes du condensateur d'entrée (24₆) par rapport à d'autres composants de ladite autre cellule de lecture (21₆).

9. Procédé selon la revendication 6, suivant lequel la connexion électrique qui était prévue dans l'affectation initiale de un-à-une des éléments photosensibles (11) aux cellules de lecture (21), pour relier électriquement un des éléments photosensibles (11₈) à la connexion d'assemblage (30s) correspondante, est supprimée,
et une connexion électrique supplémentaire (191) est ajoutée au circuit de détection (10) pour connecter électriquement ladite connexion d'assemblage (30₈) à une borne de masse (M) du circuit de détection.

10. Procédé selon l'une quelconque des revendications précédentes, suivant lequel le capteur d'image matriciel hybride (100) est destiné à une application spectrophotométrique ou à une application mixte de spectrophotométrie et d'imagerie.

11. Procédé selon l'une quelconque des revendications précédentes, suivant lequel le circuit de détection (10) est en matériau semi-conducteur silicium, ou comporte une couche active (A11) en alliage de mercure, cadmium et tellure, ou en alliage d'indium, galium et arsenic, ou en alliage d'indium et antimoine, dans laquelle sont formés les éléments photosensibles (11), ou comporte des structures de type super-réseaux.

12. Procédé selon l'une quelconque des revendications précédentes, comprenant en outre une étape de fabrication du capteur d'image matriciel hybride (100), conformément aux connexions électriques modifiées de façon à ce que ledit capteur d'image matriciel hybride comporte les entités de détection composées.

13. Capteur d'image matriciel hybride (100), conçu et fabriqué en mettant en œuvre un procédé de redimensionnement d'entités de détection qui est conforme à l'une quelconque des revendications précédentes.

14. Capteur d'image matriciel hybride (100) selon la revendication 13, dans lequel le pas de lignes et le pas de colonnes des éléments photosensibles (11) dans la matrice du circuit de détection (10), sont identiques.

## Patentansprüche

1. Verfahren zur Neudimensionierung der Erfassungsentitäten eines hybriden Matrixbildsensors (100), wobei der hybride Matrixbildsensor enthält:
- einen Erfassungsschaltkreis (10), der eine Matrix lichtempfindlicher Elemente (11) mit einem Zeilenabstand und einem Spaltenabstand enthält, wobei jedes lichtempfindliche Element sich an einer Schnittstelle einer Zeile und einer Spalte befindet;
- einen Leseschaltkreis (20), der eine Matrix von Lesezellen (21) enthält, die den gleichen Zeilenabstand und den gleichen Spaltenabstand besitzt wie der Erfassungsschaltkreis (10), wobei jede Lesezelle sich an einer Schnittstelle einer der Zeilen und einer der Spalten befindet; und
- Verbindungen (30) zum Zusammenbau des Erfassungsschaltkreises (10) mit dem Leseschaltkreis (20), die zwischen dem Erfassungsschaltkreis und dem Leseschaltkreis angeordnet und je ursprünglich konzipiert sind, ein einziges der lichtempfindlichen Elemente (11) mit einer einzigen der Lesezellen (21), die ursprünglich für das lichtempfindliche Element bestimmt ist, gemäß einer ursprünglichen Eins-zu-eins-Zuweisung starr und elektrisch zu verbinden, getrennt von den anderen Zusammenbauverbindungen, um ein Erfassungssignal (Iₚₕₒₜₒ) an die Lesezelle zu übertragen, das vom lichtempfindlichen Element unter der Wirkung einer empfangenen Strahlung (R) erzeugt wird,
wobei elektrische Verbindungen, die vom Erfassungsschaltkreis (10) oder vom Leseschaltkreis (20) getragen werden und an den Zusammenbauverbindungen (30) enden, bezüglich der ursprünglichen Eins-zu-eins-Zuweisung verändert werden, um eine Teileinheit (SS) mehrerer benachbarter lichtempfindlicher Elemente (11₁-11₅) elektrisch mit nur einer der Lesezellen (21₃) zu verbinden, die für die Teileinheit lichtempfindlicher Elemente dediziert wird, getrennt von anderen Teileinheiten lichtempfindlicher Elemente, um zusammengesetzte Erfassungsentitäten zu bilden, **dadurch gekennzeichnet, dass** zusätzliche elektrische Verbindungen, die vom Leseschaltkreis (20) getragen werden, außerdem verändert werden, um elektronische Bauteile, die ursprünglich zu Lesezellen (21₁, 21₂, 21₄, 21₅) gehörten, deren Lesezellen aber nicht für Teileinheiten mehrerer lichtempfindlicher Elemente dediziert wurden, an die Lesezellen (21₃), die mit den Teileinheiten (SS) mehrerer lichtempfindlicher Elemente (11₁-11₅) verbunden sind, gemäß einer Neuzuweisung von Ressourcen des Leseschaltkreises anzuschließen.

2. Verfahren nach Anspruch 1, wobei die elektrischen Verbindungen, die verändert werden, um jede Teileinheit (SS) mehrerer lichtempfindlicher Elemente (11₁-11₅) elektrisch mit einer einzigen der Lesezellen (21₃) zu verbinden, die für die Teileinheit lichtempfindlicher Elemente dediziert wird, zu Metallisierungsebenen (19, 29) des Erfassungsschaltkreises (10) oder des Leseschaltkreises (20) gehören.

3. Verfahren nach Anspruch 1 oder 2, wobei die elektrischen Verbindungen, die vom Erfassungsschaltkreis (10) oder vom Leseschaltkreis (20) getragen werden und die verändert werden, um die zusammengesetzten Erfassungsentitäten zu bilden, so verändert werden, dass die Teileinheiten (SS) mehrerer benachbarter lichtempfindlicher Elemente (11₁-11₅), die mit unterschiedlichen Lesezellen (21₃) verbunden sind, ein Kachelungsmuster bilden, das in der Matrix des Erfassungsschaltkreises (10) wiederholt wird, oder mehrere Kachelungsmuster bilden, die je in jeweiligen Bereichen der Matrix des Erfassungsschaltkreises wiederholt werden.

4. Verfahren nach einem der vorhergehenden Ansprüche, wobei bestimmte der Zusammenbauverbindungen (30) außerdem verändert oder entfernt werden können zusätzlich zu den elektrischen Verbindungen, die verändert werden, um jede Teileinheit (SS) lichtempfindlicher Elemente (11₁-11₅) elektrisch mit der Lesezelle (21₃) zu verbinden, die für die Teileinheit lichtempfindlicher Elemente dediziert ist.

5. Verfahren nach einem der vorhergehenden Ansprüche, wobei die elektronischen Bauteile, die gemäß der Neuzuweisung von Ressourcen des Leseschaltkreises (20) angeschlossen werden, Kondensatoren sind, insbesondere Integrationskondensatoren (24₁, 24₂, 24₄, 24₅), Filterkondensatoren (25₁, 25₂, 25₄, 25₅) oder Lesekondensatoren (27₁, 27₂, 27₄, 27₅), und vorzugsweise Kondensatoren, die in Metallisierungsebenen (29) des Leseschaltkreises enthalten sind.

6. Verfahren nach einem der vorhergehenden Ansprüche, wobei bestimmte der elektrischen Verbindungen, die vom Erfassungsschaltkreis (10) oder vom Leseschaltkreis (20) getragen werden, außerdem verändert werden, um eine elektrische Verbindung zu entfernen, die in der ursprünglichen Eins-zu-eins-Zuweisung der lichtempfindlichen Elemente (11) zu den Lesezellen (21) zwischen einem der lichtempfindlichen Elemente und einer der Lesezellen, Bezugszelle (21₇) genannt, vorgesehen war,
und um einen Eingang der Bezugszelle (21₇) elektrisch zu verbinden, damit die Bezugszelle am Ausgang ein Signal liefert, das für Schwankungen repräsentativ ist, die sich auf ein Lesesignal auswirken, das von mindestens einer anderen der Lesezellen (21₃) geliefert wird, die mit mindestens einem lichtempfindlichen Element (11₁-11₅) verbunden bleibt.

7. Verfahren nach Anspruch 6, wobei bestimmte der elektrischen Verbindungen, die vom Erfassungsschaltkreis (10) oder vom Leseschaltkreis (20) getragen werden, außerdem verändert werden, um den Eingang der Bezugszelle (21₇) mit einer ersten Klemme eines Kondensators, Eingangskondensator (24₆) genannt, zu verbinden, und um eine zweite Klemme des Eingangskondensators mit einer Masseklemme (M) des Erfassungsschaltkreises oder des Leseschaltkreises zu verbinden.

8. Verfahren nach Anspruch 7, wobei der Eingangskondensator (24₆) zu einer anderen der Lesezellen (21₆) in der ursprünglichen Eins-zu-eins-Zuweisung der lichtempfindlichen Elemente (11) zu den Lesezellen (21) gehörte, wobei diese andere Lesezelle nicht mehr mit einem der lichtempfindlichen Elemente verbunden ist, nachdem die zusammengesetzten Erfassungsentitäten gebildet wurden,
und bestimmte der elektrischen Verbindungen, die vom Erfassungsschaltkreis (10) oder vom Leseschaltkreis (20) getragen werden, außerdem verändert werden, um die erste und zweite Klemme des Eingangskondensators (24₆) bezüglich anderer Bauteile der anderen Lesezelle (21₆) elektrisch zu isolieren.

9. Verfahren nach Anspruch 6, wobei die elektrische Verbindung, die in der ursprünglichen Eins-zu-eins-Zuweisung der lichtempfindlichen Elemente (11) zu den Lesezellen (21) vorgesehen war, um eines der lichtempfindlichen Elemente (11s) mit der entsprechenden Zusammenbauverbindung (30s) elektrisch zu verbinden, entfernt wird,
und eine zusätzliche elektrische Verbindung (191) zum Erfassungsschaltkreis (10) hinzugefügt wird, um die Zusammenbauverbindung (30s) elektrisch mit einer Masseklemme (M) des Erfassungsschaltkreises zu verbinden.

10. Verfahren nach einem der vorhergehenden Ansprüche, wobei der hybride Matrixbildsensor (100) für eine spektrophotometrische Anwendung oder für eine Mischanwendung der Spektrophotometrie und der Bilderzeugung bestimmt ist.

11. Verfahren nach einem der vorhergehenden Ansprüche, wobei der Erfassungsschaltkreis (10) aus Silicium-Halbleitermaterial ist, oder eine aktive Schicht (A11) aus Quecksilber-, Cadmium- und Tellurlegierung, oder aus Indium-, Gallium- und Arsenlegierung, oder aus Indium- und Antimonlegierung aufweist, in der die lichtempfindlichen Elemente (11) gebildet werden, oder Strukturen der Art Übergitter aufweist.

12. Verfahren nach einem der vorhergehenden Ansprüche, das außerdem einen Schritt der Herstellung des hybriden Matrixbildsensors (100) gemäß den veränderten elektrischen Verbindungen enthält, damit der hybride Matrixbildsensor die zusammengesetzten Erfassungsentitäten aufweist.

13. Hybrider Matrixbildsensor (100), konzipiert und hergestellt durch Anwendung eines Verfahrens der Neudimensionierung von Erfassungsentitäten, das einem beliebigen der vorhergehenden Ansprüche entspricht.

14. Hybrider Matrixbildsensor (100) nach Anspruch 13, wobei der Zeilenabstand und der Spaltenabstand der lichtempfindlichen Elemente (11) in der Matrix des Erfassungsschaltkreises (10) gleich sind.

## Claims

1. A method for resizing the detection entities of a hybrid matrix image sensor (100), said hybrid matrix image sensor comprising:
- a detection circuit (10), comprising a matrix of photosensitive elements (11) with a row pitch and a column pitch, each photosensitive element being located at an intersection between a row and a column;
- a read-out circuit (20), comprising a matrix of read-out cells (21) which has the same row pitch and the same column pitch as the detection circuit (10), each read-out cell being located at an intersection between one of the rows and one of the columns; and
- assembly connections (30) of the detection circuit (10) to the read-out circuit (20), which are arranged between said detection circuit and said read-out circuit, and which are each initially designed to rigidly and electrically connect, in an initial one-to-one allocation, only one of the photosensitive elements (11) to only one of the read-out cells (21) which is initially dedicated to said photosensitive element, separately from the other assembly connections in order to transfer a detection signal (Iₚₕₒₜₒ) to the read-out cell, which detection signal is produced by the photosensitive element due to received radiation (R),
wherein electrical connections that are carried by the detection circuit (10) or by the read-out circuit (20) and that lead to the assembly connections (30), are modified with respect to said initial one-to-one allocation to electrically connect a subset (SS) of several adjacent photosensitive elements (11₁-11₅) to only one of the read-out cells (21₃) which becomes dedicated to said subset of photosensitive elements, separately from other subsets of photosensitive elements, so as to form compound detection entities,
**characterised in that** additional electrical connections which are carried by the read-out circuit (20), are also modified to electrically connect to the read-out cells (21₃) connected to the subsets (SS) of several photosensitive elements (11₁-11₅), according to a reallocation of resources of the read-out circuit, electronic components which initially belonged to read-out cells (21₁, 21₂, 21₄, 21₅) but these latter read-out cells not dedicated to subsets of several photosensitive elements.

2. The method according to claim 1, wherein the electrical connections which are modified to electrically connect each subset (SS) of several photosensitive elements (11₁-11₅) to only one of the read-out cells (21₃) which becomes dedicated to said subset of photosensitive elements, belong to metallisation levels (19, 29) of the detection circuit (10) or of the read-out circuit (20).

3. The method according to claim 1 or 2, wherein the electrical connections which are carried by the detection circuit (10) or by the read-out circuit (20) and which are modified to form the compound detection entities, are modified so that the subsets (SS) of several adjacent photosensitive elements (11₁-11₅) which are connected to different read-out cells (21₃) form a tiling pattern which is repeated in the matrix of the detection circuit (10), or a plurality of tiling patterns which are each repeated in respective areas of the matrix of the detection circuit.

4. The method according to any one of the preceding claims, wherein some of the assembly connections (30) can also be modified or removed, in addition to the electrical connections which are modified in order to electrically connect each sub-assembly (SS) of photosensitive elements (11₁-11₅) to the read-out cell (21₃) that is dedicated to said sub-assembly of photosensitive elements.

5. The method according to any one of the preceding claims, wherein the electronic components which are connected according to the reallocation of resources of the read-out circuit (20) are capacitors, in particular integration capacitors (24₁, 24₂, 24₄, 24₅), filter capacitors (25₁, 25₂, 25₄, 25₅) or read-out capacitors (27₁, 27₂, 27₄, 27₅), and preferably capacitors which are contained in metallisation levels (29) of the read-out circuit.

6. The method according to any one of the preceding claims, wherein some of the electrical connections which are carried by the detection circuit (10) or the read-out circuit (20) are also modified to remove an electrical connection which was provided in the initial one-to-one allocation of the photosensitive elements (11) to the read-out cells (21), between one of the photosensitive elements and one of the read-out cells, referred to as a reference cell (21₇),
and to electrically connect an input of the reference cell (21₇) so that said reference cell outputs a signal representative of fluctuations which affect a read-out signal output by at least one other of the read-out cells (21₃) which remains connected to at least one photosensitive element (11₁-11₅).

7. The method according to claim 6, wherein some of the electrical connections that are carried by the detection circuit (10) or the read-out circuit (20) are also modified to connect the input of the reference cell (21₇) to a first terminal of a capacitor, referred to as input capacitor (24₆), and to connect a second terminal of the input capacitor to a ground terminal (M) of the detection circuit or of the read-out circuit.

8. The method according to claim 7, wherein the input capacitor (24₆) belonged to another of the read-out cells (21₆) in the initial one-to-one allocation of the photosensitive elements (11) to the read-out cells (21), this another read-out cell no longer being connected to any of the photosensitive elements after the compound detection entities have been formed,
and some of the electrical connections that are carried by the detection circuit (10) or the read-out circuit (20) are also modified to electrically isolate the first and second terminals of the input capacitor (24₆) from other components of said another read-out cell (21₆).

9. The method according to claim 6, wherein the electrical connection which was provided in the initial one-to-one allocation of the photosensitive elements (11) to the read-out cells (21), for electrically connecting one of the photosensitive elements (11s) to the corresponding assembly connection (30s), is removed,
and an additional electrical connection (191) is added to the detection circuit (10) to electrically connect said assembly connection (30s) to a ground terminal (M) of the detection circuit.

10. The method according to any one of the preceding claims, wherein the hybrid matrix image sensor (100) is intended to a spectrophotometric or mixed spectrophotometric-and-imaging application.

11. The method according to any one of the preceding claims, wherein the detection circuit (10) is made of silicon semiconductor material, or includes an active layer (A11) made of mercury-cadmium-tellurium alloy, or indium-gallium-arsenic alloy, or indium-antimony alloy, in which the photosensitive elements (11) are formed, or which includes superlattice-type structures.

12. The method according to any one of the preceding claims, further comprising a step of manufacturing the hybrid matrix image sensor (100), in accordance with the modified electrical connections so that said hybrid matrix image sensor includes the compound detection entities.

13. An hybrid matrix image sensor (100), designed and manufactured by implementing a method for resizing detection entities in accordance with any one of the preceding claims.

14. The hybrid matrix image sensor (100) according to claim 13, wherein the row pitch and the column pitch of the photosensitive elements (11) in the matrix of the detection circuit (10) are identical.
